# EUROPEAN PATENT APPLICATION

(11) **EP 1 369 991 A2**
(43) Date of publication of application: **10.12.2003**
(21) Application number: 03252938.0
(22) Date of filing: 12.05.2003
(51) Int. Cl.: H03F 3/193

(54) **Power amplifier**

(30) Priority: 07.06.2002 GB 0213153
(71) Applicant: Sony United Kingdom Limited, Weybridge, Surrey KT13 0XW (GB)
(72) Inventor: Glynn, Stuart Francis, Reading, Berkshire, RG6 7LT (GB); Clifton, John Christopher, Hook, Hampshire (GB)
(74) Representative: Smith, Samuel Leonard

(57) **Abstract**

A power amplifier for a mobile transceiver including an output stage transistor, a DC supply rail and a feed inductor for connecting the output stage transistor to the DC supply rail and for isolating the DC supply rail from radio frequency signals in the output stage transistor wherein the output power of the mobile transceiver is determined by detecting the current consumption of the output stage transistor by detecting the voltage drop across the feed inductor.

## Description

The present invention relates to a power amplifier for a mobile transceiver making use of a method of determining the output power of the mobile transceiver.

In mobile transceivers, particularly mobile telephones, also known as cell phones, it is often desirable to be able to control accurately the output power of the transmitter. In the case of mobile telephones, so as to conserve battery power and reduce interference with other telephones, the mobile phone operates at the minimum necessary power to provide an adequate signal for reception by a base station. In this respect, the base station may provide a return signal to the mobile telephone to indicate the required transmission power for the telephone.

Although it is possible to provide an open-loop control for the power amplifier of a mobile transceiver, the properties of the components of the mobile transceiver can vary, for instance with time or temperature. Therefore, it is preferred to provide closed-loop control.

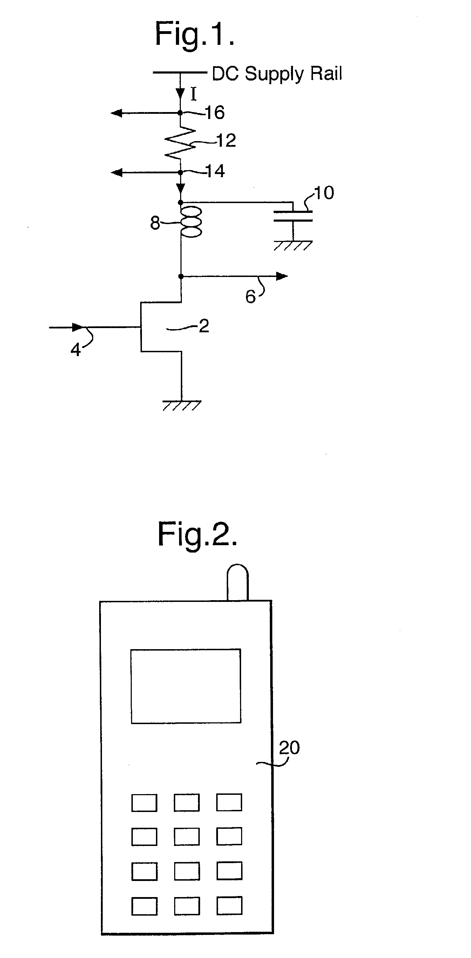

Figure 1 of the accompanying drawings illustrates a known arrangement for detecting the output power of the power amplifier of a mobile transceiver.

The output stage transistor 2 is connected between a DC supply rail and ground and a radio frequency signal provided at an input 4 is amplified and passed to a signal path 6. A feed inductor 8 connects the DC supply rail to the output stage transistor 2 and, together with a capacitor 10, isolates the DC supply rail from the radio frequency signal amplified by the output stage transistor 2.

In order to calculate the output power of the output stage transistor 2, a dedicated current sensor resistor 12 is connected in series with the feed inductor 8 and output stage transistor 2. The resistor 12 may be of a well defined resistance. Therefore, by providing a first detector connection 14 and a second detector connection 16 either side of the resistor 12 and measuring the voltage drop across the resistor 12, it is possible to calculate the current flowing through the resistor 12 and, hence, through the output stage transistor 2.

In this way, the output power of the output stage transistor 2 may be detected and then controlled according to the requirements of the mobile transceiver.

It will be appreciated that the efficiency of a mobile transceiver is of considerable importance. In other words, the ratio of the radio frequency output power from the power amplifier to the DC power it consumes should be as high as possible. This minimises the power consumption of any battery. Unfortunately, of course, the power detection method described above with reference to Figure 1 consumes power in the sensor resistor and, therefore, reduces the overall efficiency. Typically the sensor resistor 12 will have a resistance of approximately 100 mohms which will result in a reasonably significant loss of power and reduction in efficiency.

It is an object of the present invention to overcome or at least reduce these problems.

According to the present invention there is provided a method of determining the output power of a mobile transceiver having a power amplifier with an output stage transistor connected to a DC supply rail by a feed inductor, the method including:
detecting the current consumption of the output stage transistor by detecting the voltage drop across the feed inductor.

According to the present invention there is also provided a power amplifier for a mobile transceiver including:-
an output stage transistor;
a DC supply rail; and
a feed inductor for connecting the output stage transistor to the DC supply rail and for isolating the DC supply rail from radio frequency signals in the output stage transistor; wherein
a first detector connection is provided to the feed inductor on the side of the output stage transistor so as to allow the voltage drop across the feed inductor to be detected and, hence, current through the feed inductor and the output stage transistor to be calculated.

In this way, the need for a dedicated current sensing resistor is avoided. The present invention makes use of the inevitable resistive qualities of the feed inductor used to isolate the DC supply rail from radio frequency signals. Hence, in measuring the current through the output stage transistor, no additional power is consumed.

Previously, front-ends of mobile transceivers did not allow detection of the voltage at the transistor side of the feed inductor. Connection points were only provided for the signal path and it was not possible to measure assuredly the voltage at the feed inductor. In particular, unknown voltage drops occur along the signal path.

If the voltage difference between the DC supply rail and ground is known, it is possible to determine the voltage drop across the feed inductor by measuring the voltage between the first detector connection and ground and subtracting this from the DC supply voltage. However, alternatively, the voltage drop may be measured by taking the voltage difference between the first detector connection and the DC supply rail.

It will be apparent from the above that the feed inductor is connected directly to the DC supply rail without any intermediate current sensing resistor.

Furthermore, a signal path may be connected to a point between the feed inductor and the output stage transistor, the signal path providing an output for an antenna and including at least a matching network.

Thus, as mentioned above, the first detector connection provides a path for measuring the voltage at the feed inductor without connection to the signal path and any associated voltage drops, for instance resulting from the matching network.

Hence, the first detector connection may provide a first output for a voltage detector without any intermediate component between the first output and feed inductor.

Alternatively, a resistive load and a capacitive shunt may be provided between the first detector connection and the first output so as to isolate the first output from radio frequency signals in the output stage transistor.

The resistive load may have a significantly higher resistance than the resistive path of the feed inductor and, indeed, with a voltage detector, such as an op-amp of very high input impedance, an insignificant amount of current will flow through the resistive load.

A voltage detector may be connected to the first output for use in calculating the voltage drop across the feed inductor.

In other words, instead of providing a first output for connection to an external device, the voltage detector may be constructed integrally with the components of the power amplifier.

Preferably, a second detector connection is provided to the feed inductor on the side of the DC supply rail so as to allow the voltage across the feed inductor to be detected by means of the first and second detector connections.

In this way, it is assured that the resistive nature of the path from the feed inductor to the connection point on the DC supply rail does not influence the voltage drop calculated for the feed inductor.

Indeed, the second detector connection may provide a second output for a voltage detector without any intermediate component between the second output and the feed inductor.

In this way, a second dedicated output may be provided allowing an external voltage detector to detect the voltage drop across the feed inductor.

Alternatively, as mentioned above, a voltage detector may be connected to the first and second outputs for detecting the voltage drop across the feed inductor and the voltage detector may be provided integrally as part of the power amplifier.

Preferably, a control circuit is provided for controlling the gain of at least the output stage transistor according to the detected voltage drop across the feed inductor.

The control circuit may be of any known type and may be provided integrally as part of the power amplifier so as to provide a self-contained closed-loop power amplifier having improved efficiency.

The power amplifier may be provided as a module for use in the assembly of a mobile transceiver. Indeed, a mobile transceiver may be provided including the power amplifier or module described above.

The invention will be more clearly understood from the following description, given by way of example only, with reference to the accompanying drawings, in which:
Fig. 1 illustrates a power amplifier output stage with known current sensing;
Fig. 2 illustrates a mobile transceiver embodying the present invention;
Fig. 3 illustrates the topology of a quad-band front-end embodying the present invention; and
Fig. 4 illustrates an embodiment of the present invention.

The present invention is suitable for use in the front-end of a mobile transceiver such as the mobile telephone 20 illustrated in Figure 2. The mobile telephone 20 may conform to GSM, EDGE or UMTS standards and may be single, dual, triple or quad-band.

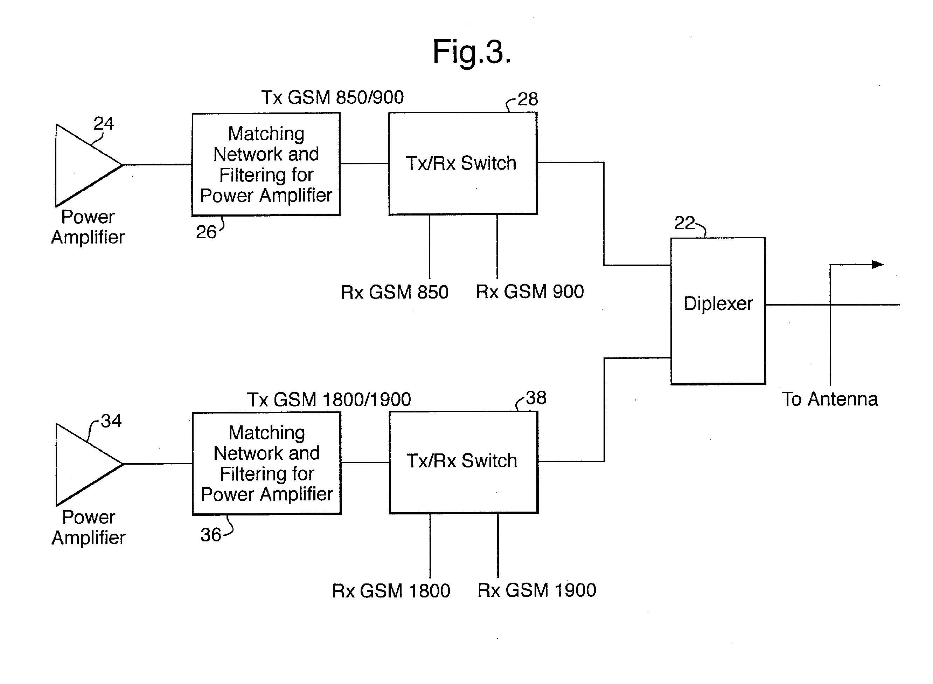

Figure 3 illustrates schematically an embodiment of the present invention. In particular, Figure 3 illustrates the components of a front-end for a mobile transceiver. These components may be provided as discrete components or combined together as one or more modules.

The embodiment of Figure 3 relates to a quad-band transceiver. In particular, it illustrates two signal paths, one for GSM 850 and GSM 900 signals and the other for GSM 1800 and GSM 1900 signals. It should be appreciated, nevertheless, that the present invention is directly applicable to single-band, dual-band and triple-band transceivers.

A diplexer 22 switches between the two signal paths and isolates the GSM 850 and GSM 900 bands from the GSM 1800 and GSM 1900 bands.

For transmission of GSM 850 and GSM 900 bands, a signal path is provided between a power amplifier 24 and the diplexer 22. The signal path includes a matching network 26 for matching the low impedance output of the power amplifier 24 to the high impendence input of the antenna. This ensures optimum output power and efficiency. The matching network 26 may also include filtering of the signal derived from the power amplifier 24 so as to minimise the emission of unwanted harmonics. The signal path then includes transmit/receive switches 28.

During transmission of a signal, the transmit/receive switches 28 connect the signal from the power amplifier 24 to the antenna, but isolate from the signal path any components (not illustrated) for receiving signals. On the other hand, during a receive mode, the transmit/receive switches 28 prevent the matching components of the power amplifier 24 from loading the receive path and instead connect any radio frequency signal received by the antenna to the receive components (not illustrated) downstream of the transmit/receive switch 28.

For the illustrated quad-band arrangement, a directly equivalent power amplifier 34, matching network 36 and transmit/receive switches 38 are provided for the GSM 1800/GSM 1900 path.

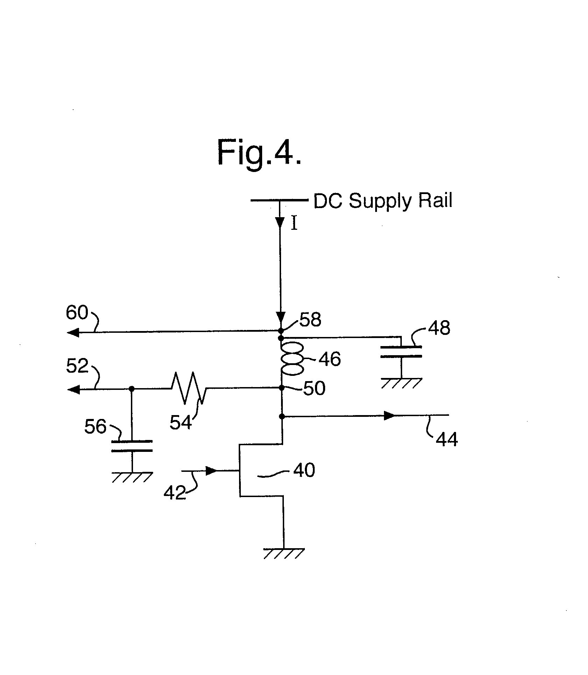

The power amplifiers 24 and 34 are usually provided with multiple stages. Irrespective, they must necessarily have a final or output stage. Figure 4 illustrates an output stage embodied according to the present invention.

The output stage may be constructed using a transistor of any known form. However, in the illustrated embodiment, the output stage transistor 40 is an FET.

The transistor 40 is connected between the DC supply rail and ground using appropriate bias circuitry (not illustrated) so as to amplify a radio frequency signal provided at input 42 and provide the amplified output signal to a signal path 44.

As is well known, a feed inductor 46 is provided between the transistor 40 and the DC supply rail. The feed inductor 46 is used to prevent the radio frequency signal being amplified by transistor 40 from interfering with the DC supply rail. In particular, for high frequencies, the feed inductor 46 appears as open-circuit.

Preferably, as illustrated, a shunt capacitor 48 also connects the supply rail side of the feed inductor 46 to ground. As will be appreciated, the shunt capacitor 48 appears as open circuit to DC, but as closed circuit to high frequency AC. Hence, any radio frequencies managing to pass through the feed inductor 46 will pass to earth through the shunt capacitor 48.

The present invention is based on a recognition that the feed inductor 46 will necessarily have a resistive quality. It is further recognised that advantage may be taken of this resistive quality to calculate the DC current flowing through the feed inductor 46 and, hence, through the transistor 40. This may then be used in a known manner to estimate the power output of transistor 40.

Thus, the present application recognises for the first time the desirability of providing a feed inductor 46 with a well defined resistance. In general, it is expected that the resistance of the feed inductor 46 will be approximately 80 mohms.

As illustrated, a connection 50 is provided to the feed inductor 46 on the side of the transistor 40. The connection 50 allows the voltage at this part of the feed inductor 46 to be monitored. An output for external connection may feed directly from connection 50 enabling a detector to monitor the voltage as appropriate. However, as illustrated, circuitry is provided to isolate the output from the radio frequency signal. In particular, between an output 52 and the connection 50, a resistor 54 is connected in series. Furthermore, a capacitor 56 connects a point between the output 52 and resistor 54 to ground.

The capacitor 56 shorts to ground any radio frequency signals from connection 50.

The resistor 54 may be of a high value compared to the resistive element of the feed inductor 46 so as to provide an insignificant effect on the voltage reading for connection 50. In particular, the resistor 54 may have a value of as little as 150 ohms or, preferably, 500 ohms or 1 kohm.

On the basis that there is little between the feed inductor 46 and the DC supply rail, it is possible to use the voltage detected for connection 50 to determine the voltage drop across the feed inductor 46. In particular, the voltage drop can be taken to be the difference between the voltage at the connection 50 and the voltage of the DC supply rail. This may be measured directly or by calculating the difference between a) the DC supply rail and b) the voltage between the connection 50 and ground.

Since the path length from the feed inductor 46 to the DC supply rail is often unknown and, indeed, might include some resistive element, in the preferred embodiment, as illustrated in Figure 4, a second connection 58 is provided to the feed inductor 46 on the side of the DC supply rail. This may be fed to an output 60, such that the voltage drop across the feed inductor 46 may be detected directly from outputs 52 and 60.

In a preferred embodiment, the power amplifier is constructed with a feed inductor 46 of known resistance, for example 80 mohms. By ensuring that the resistance meets a tight tolerance, for instance plus or minus 1%, it is sufficient merely to measure the voltage drop across the feed inductor 46 so as to determine the current through the feed inductor 46 and, hence, that through the transistor 40.

In this way, the outputs 52 and 60 may be connected to otherwise known control circuitry. For instance, an op-amp may be used to detect the voltage difference between the outputs 52 and 60 and the output of the op-amp used to control the bias on the transistor 40 and, hence, the output power.

As will be appreciated from the above, the arrangement of Figure 4 may be implemented using discrete components in a mobile transceiver or, alternatively, it may be provided as one or more modules.

## Claims

1. A power amplifier for a mobile transceiver including:-
an output stage transistor;
a DC supply rail; and
a feed inductor for connecting the output stage transistor to the DC supply rail and for isolating the DC supply rail from radio frequency signals in the output stage transistor; wherein
a first detector connection is provided to the feed inductor on the side of the output stage transistor so as to allow the voltage drop across the feed inductor to be detected and, hence, current through the feed inductor and the output stage transistor to be calculated.

2. A power amplifier according to claim 1 wherein:
the feed inductor is connected directly to the DC supply rail without any intermediate current sensing resistor.

3. A module according to claim 1 or 2 further including:
a signal path connected to a point between the feed inductor and the output stage transistor, the signal path providing an output for an antenna and including at least a matching network.

4. A power amplifier according to claim 1, 2 or 3 wherein:
the first detector connection provides a first output for a voltage detector without any intermediate component between the first output and the feed inductor.

5. A power amplifier according to claim 1, 2 or 3 wherein:
the first detector connection provides a first output for a voltage detector, a resistive load and a capacitive shunt being provided between the first detector connection and the first output for isolating the first output from radio frequency signals in the output stage transistor and no other intermediate component being provided between the first output and the feed inductor.

6. A power amplifier according to claim 4 or 5 further including:
a voltage detector connected to the first output for use in calculating the voltage drop across the feed inductor.

7. A power amplifier according to claim 4 or 5 wherein:
a second detector connection is provided to the feed inductor on the side of the DC supply rail so as to allow the voltage across the feed inductor to be detected by means of the first and second detector connections.

8. A power amplifier according to claim 7 wherein:
the second detector connection provides a second output for a voltage detector without any intermediate component between the second output and the feed inductor.

9. A power amplifier according to claim 8 further including:
a voltage detector connected to the first and second outputs for detecting the voltage drop across the feed inductor.

10. A power amplifier according to claim 6 or 9 further including:
a control circuit for controlling the gain of at least the output stage transistor according to the detected voltage drop across the feed inductor.

11. A module for a mobile transceiver including:
a power amplifier according to claim 4, 5, 7 or 8, the first output being provided as an external connection to the module.

12. A module for a mobile transceiver including:
a power amplifier according to claim 8, the first and second outputs being provided as external connections to the module.

13. A module for a mobile transceiver including a power amplifier according to claim 6, 9 or 10.

14. A mobile transceiver including a power amplifier according to any one of claims 1 to 10 or a module according to claim 11, 12 or 13.

15. A method of determining the output power of a mobile transceiver having a power amplifier with an output stage transistor connected to a DC supply rail by a feed inductor, the method including:
detecting the current consumption of the output stage transistor by detecting the voltage drop across the feed inductor.
